(19) Europäisches Patentamt / European Patent Office / Office européen des brevets

(11) **EP 2 608 287 B1**

(12) **EUROPEAN PATENT SPECIFICATION**

(45) Date of publication and mention of the grant of the patent:
**16.04.2014 Bulletin 2014/16**

(51) Int Cl.:
*H01L 41/18* (2006.01)    *H01L 41/37* (2013.01)
*H01L 41/257* (2013.01)    *H01L 41/314* (2013.01)

(21) Application number: **11195339.4**

(22) Date of filing: **22.12.2011**

(54) **Flexible piezoelectric material, production and use thereof**

Flexibles piezoelektrisches Material sowie Herstellung und Verwendung davon

Matériau piézoélectrique flexible, production et utilisation associées

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.06.2013 Bulletin 2013/26**

(73) Proprietor: **Meggitt A/S**
**3490 Kvistgaard (DK)**

(72) Inventors:
• **Zawada, Tomasz**
**2000 Frederiksberg (DK)**
• **Hansen, Karsten**
**2625 Vallensbæk (DK)**
• **Astafiev, Konstantin**
**2300 København (DK)**
• **Ringgaard, Erling**
**2880 Bagsværd (DK)**

(74) Representative: **Zacco Denmark A/S**
**Hans Bekkevolds Allé 7**
**2900 Hellerup (DK)**

(56) References cited:
**EP-A1- 1 791 195**    **US-A- 5 043 622**

• **ESTEVAM GIULIANO ET AL: "Photopyroelectric response of PTCa/PEEK composite", REVIEW OF SCIENTIFIC INSTRUMENTS, AIP, MELVILLE, NY, US, vol. 82, no. 2, 17 February 2011 (2011-02-17), pages 23903-23903, XP012146170, ISSN: 0034-6748, DOI: 10.1063/1.3552193**
• **AKDOGAN E K ET AL: "Piezoelectric composites for sensor and actuator applications", IEEE TRANSACTIONS ON ULTRASONICS, FERROELECTRICS AND FREQUENCY CONTROL, IEEE, US, vol. 52, no. 5, 1 May 2005 (2005-05-01), pages 746-775, XP011367393, ISSN: 0885-3010, DOI: 10.1109/TUFFC.2005.1503962**
• **BABU I ET AL: "Processing and characterization of piezoelectric 0-3 PZT/LCT/PA composites; Processing and characterization of piezoelectric 0-3 PZT/LCT/PA composites", JOURNAL OF PHYSICS D. APPLIED PHYSICS, IOP PUBLISHING, BRISTOL, GB, vol. 43, no. 42, 7 October 2010 (2010-10-07), page 425402, XP020199137, ISSN: 0022-3727, DOI: 10.1088/0022-3727/43/42/425402**

**Description**

**Field of the invention**

This invention generally relates to a composite piezoelectric material, manufacturing of the composite material and use of this composite material in piezoelectric components. More particularly, the invention relates to piezoelectric thick film materials or piezoelectric paint being a composite piezoelectric material comprising piezoelectric particles randomly dispersed within a polymer matrix.

**Background of the invention**

The value of the composite piezoelectric material is characterized by its ability to capture signals emitted by the substrate material to which it is attached. The signals may e.g. originate from vibrations, crack formation, torsion, movement or transformations of the substrate material.

The document US 5,702,629 discloses methods and compositions for preparing piezoelectric ceramic-polymer composites in the form of compacted disks.

More recently composite piezoelectric materials have been described in the form of pastes or paints, i.e. in the form of a mixture of a soft and malleable consistency. These materials are also referred to as piezoelectric thick film materials or piezoelectric paint. In particular the usability of such materials for structural health monitoring applications has attracted considerable attention.

For example, X. Li and Y.Zhang: "Analytical study of piezoelectric paint sensor for acoustic emission-based fracture monitoring", in Fatigue & Fracture of Engineering Materials & Structures, Volume 31, Issue 8, pages 684-694, August 2008, have studied the properties of a piezoelectric paint for the acoustic emission technique for non-destructive evaluation such as fracture monitoring in metal, concrete and composite structures. Composites according to this reference comprises piezoelectric paints constituted of tiny piezoelectric particles mixed within polymer matrix and belonging to the '0-3' piezoelectric composite meaning that the piezoelectrically active ceramic particles are randomly dispersed in a three-dimensionally connected polymer matrix. The advantages of this material is its ease of fabrication into complex shapes including large flexible thin sheets, extruded bars and fibres and moulded shapes and the material may conform to any curved surface.

V. Giurgiutiu and Bin Lin, "In-situ Fabricated Smart Material Active sensors for structural Health Monitoring", in Smart Materials III, ed. By Alan R. Wilson, Proceedings of SPIE Vol. 5648, have identified in-situ composite piezoelectric wafer active sensors as good candidates for reliable low-cost options for Structural Health Monitoring (SHM) smart sensor fabrication due to the ease with which their mechanical properties may be tailored, low cost ease of implementation, conformability to curved surface and compatibility with polymeric materials. The piezoelectric composite is made of a PZT powder added to an epoxy matrix phase, the paste is then spread into a mask and allowed to cure at an elevated temperature around 50 °C until hard. At last excess is removed and the composite is sanded down to final thickness.

I. Payo and J.M. Hale, "Dynamic characterization of piezoelectric paint sensors under biaxial strain", in Sensors and Actuators A 163, 2010, page 150-158, discloses a piezoelectric paint film designed to be used as a strain sensor, The composite is a suspension If milled PZT (lead zirconate titanate) ceramic powder in a polymer binder in the form of a water-based acrylic. The piezoelectric material film is applied to the substrate with a conventional spray gun directly to the top surface of the substrate. It is pointed out in the paper that the described piezoelectric paint sensors present some advantages with respect to other film sensors such as e.g. PZT ceramics and polyvinylidene fluoride (PVDF).

R. Lahtinen et al., "A piezopaint-based sensor for monitoring structure dynamics", in Smart Materials and Structures, 16, 2007, page 2571-2576, disclose a combination of a piezoelectric powder with a paint resin such as an epoxy resin which resulting paint can easily be applied to almost any surface. The paint is used as a vibration sensor e.g. on a footbridge and the paint is applied with a laboratory application such as a doctor blade with a fixed gap or alternatively by spraying. In the text page 2571, col. 1, lines 10-14, it is mentioned that vibration and strain monitoring commonly is solved by using piezoelectric polymers such as Polyvinylidene fluoride (PVDF) or strain gauges but the thermal stability of PVDF is limited to 80° and the strain gauges require elaborate temperature compensation.

K. Arlt and M. Wegener, "Piezoelectric PZT/PVDF - copolymer 0-3 Composites: Aspects on Film Preparation and Electrical Poling", Fraunhofer Institute for Applied Polymer Research (IAP), IEEE Transactions on Dielectrics and Electrical Insulation Vol. 17, No. 4, August 2010, discloses composite films of PZT (lead zirconate titanate) and different i.e. non-polar and polar PVDF (Polyvinylidene fluoride) copolymers prepared as 30-150 $\mu$m thick freestanding flexible films. The article considers the influence of the poling time and the poling-temperature regimes on piezoelectric properties achieved in the composite. The composite films are prepared by solvent casting the mixtures onto glass plates

The document US 5,951,908 disclose compositions and processes for fabrication of piezoelectric composites comprising piezoelectric particles embedded in a polymer matrix having improved figures of merit for both sensor and non-sensor applications. The improvements result from discoveries of the effects of polymer bulk compliance, polymer anisotropy, polymer melt index and polymer/ceramic wettability on performance. In order to avoid substantial void volume in the composite, the polymer matrix should wet the ceramic particles properly and diffuse into the gaps between the ceramic particles to form a cavity-free composite. Use of curable resins such as epoxy and polyurethane resins can be used to make 0-3 composites according to this document.

The document US 4,917,810 discloses a piezoelectric composite material prepared by compounding a ferroelectric ceramic powder comprising microcrystals having virtually single domains and a polymer. The ferroelectric ceramic powder can be mixed with a wide variety of polymers, molded in an arbitrary shape e.g. a sheet, subjected to a hardening treatment such as cross-linking or vulcanization and then polarized to prepare the piezoelectric composite material.

## **Definitions**

PZT - lead (P) - zirconate (Z) - titanate (T) (piezoelectric ceramic)
KNN - Alkali Niobate based material e.g. $K_{0.5} Na_{0.5} NbO_3$
AE - Acoustic Emission
$d_{33}$ - piezoelectric charge constant (p C/N = pico ($10^{-12}$) Coulomb/Newton)

It should be emphasized that the term "comprises/comprising" when used in this specification is taken to specify the presence of stated features, integers, steps or components but does not preclude the presence or addition of one or more other features, integers, steps, components or groups thereof.

"Satisfying wetting properties" indicates that a contact angle of less than 90 ° is obtained between fluid and solid substrate.

"Substrate" is the technical name used to address any parts or materials to which a film or layer of composite piezoelectric material is attached and is intended to finally function. It is critical to match substrates and piezoelectric paste as to their chemical compatibility such as e.g. wettability. Substrates need to be clean and free from surface contamination to allow proper paste adhesion.

## **Summary**

According to a first aspect the present invention relates to a paste of composite piezoelectric material according to claim 1.

According to an embodiment of the invention, the sintered piezoelectric particles are manufactured from a ceramic piezoelectric active powder which is first pressed and then sintered at a temperature above 1100°C for a period of at least 0.5 hours. Normally, the powder is pressed into a solid unit at a pressure above 500 bars, and normally the sintering temperature will be 1100-1300°C and the sintering time will be 1-2 hours. The ceramic piezoelectric active powder can be a commercially available powder e.g. of the type Pz24, Pz26, Pz59 or Lead-Free.

According to this embodiment, the sintered piezoelectric material might be subjected to crushing and milling to obtain a desired particle size of $d_{0.5}$ = 1-50 $\mu$m, normally 7-15 $\mu$m.

According to an embodiment of the invention, the cured polymer matrix is flexible and having a Young's Modulus E $\leq$ 10 GPa, normally E $\leq$ 4 GPa.

According to an embodiment of the invention, the viscosity of the paste is $\leq$ 15 Pa·s at a shear rate equal to 33.3 (1/sec) and satisfying wetting properties between the paste and substrate are obtained.

According to an embodiment of the invention, the binding matrix comprises or consists of a fluoride based polymer such as Polyvinylidene fluoride (PVDF) or any other polymer material with suitable properties.

According to an embodiment of the invention, the sintered piezoelectric particles are made of a PZT material. Alternatively, the piezoelectric particles are made of a KNN family material.

According to an embodiment of the invention, the thickness of the final layer of piezoelectric material is >10 $\mu$m.

According to a second aspect of the present invention, the invention also relates to a method of preparing a composite piezoelectric material according to claim 9.

According to an embodiment of the second aspect of the invention, the agitation is performed in a roller mill such as a triple roller mill.

According to an embodiment of the second aspect of the invention, the cured polymer matrix has a Young's Modulus E $\leq$ 10 GPa, normally E $\leq$ 4 GPa.

According to a third aspect of the present invention, the invention also relates to a method for manufacturing of a piezoelectric component, the method comprising or consisting of:

- depositing a layer of a paste of piezoelectric material according to the first aspect of the invention on a substrate, the layer being thicker than 10 µm, normally between 10-30 µm, the final layer on the substrate might be formed by depositing more than one layer of paste and each layer or combination of layers are created in the final functional thickness and shape by deposition,

- curing the deposited layer of composite piezoelectric material.

According to an embodiment of the third aspect of the invention, the curing comprises heating the deposited layer on the substrate at a temperature below 300°C, typically at a temperature in the range of 90-150°C.

According to an embodiment of the third aspect of the invention, the layer(s) of fluid composite piezoelectric material is deposited by screen-printing or pad-printing.

According to an embodiment of the third aspect of the invention, the substrate is a woven or non-woven textile, paper, polymer, curved or non-curved surface e.g. made of metal, ceramic or plastic or composite material e.g. comprising two or more of the mentioned materials.

The invention also relates to a piezoelectric component comprising a substrate and a layer of a cured composite piezoelectric material provided according to the first aspect of the invention deposited on a substrate and connected to electrodes. According to this embodiment the component can e.g. be a sensor, a transducer for structural health monitoring, an energy harvesting device or an actuator.

**Polymer matrix**

The composite piezoelectric material comprises a polymer, normally a nonreactive thermoplastic polymer which at working condition e.g. 20°C in a cured state is elastic and flexible. The polymer might be a thermoplastic fluoro polymer such as a polyvinylidene fluoride (PVDF) based polymer. That the polymer is based on PVDF means that it can be a PVDF-copolymer or comprise a mixture of polymers where PVDF constitutes more than 50 wt%. The polymer can contain one or more additives e.g. improving viscosity and wetting ability. The wettability of the paste can e.g. be increased by adding additives such as surfactants to the polymer matrix.

The polymer matrix has to have a viscosity which is adapted to the method of application and also the polymer has to be chosen in order to be adaptable to the expected working conditions. If the paste produced by the polymer is to be applied by screen-printing the viscosity of the paste should e.g. be between 2-15 Pa s during application of the paste which normally takes place at around a temperature of 20°C (water: 0.894 cP = $0.894.10^{-3}$ Pa·s).

**Piezoelectric particles**

The sintered piezoelectric particles to be used in the composite piezoelectric material can be manufactured from conventional and commercially available piezoelectric ceramic powders including soft and/or hard piezo ceramics, such as lead zirconate titanate (PZT) such as Pz24, Pz26, Pz59 and e.g. lead free piezoceramics. The PzXX powders belonging to the PZT family are sold by Meggitt A/S (Ferroperm Piezoceramics A/S). Also, a lead free piezoelectric ceramic can be used e.g. based on alkali niobate KNN (e.g. $K_{0.5}Na_{0.5}NbO_3$ ferroelectric ceramics).

The piezoelectric ceramic powder is subjected to a high pressure, e.g. above 500 bars, normally above 1500 bars e.g. using a cold isostatic press or by using uniaxial pressing. Before pressing the piezoelectric ceramic powder can be placed in a mould mixed with a pore former, causing blocks of pressured piezoelectric ceramic powder to be formed. The pressed piezoelectric ceramic powder e.g. in the form of blocks is sintered at a temperature above 1000°C for a time period between ½-2 hours. Normally the temperature will be above 1100°C and normally the duration of the sintering will be above 1 hr independent of sintering temperature.

After sintering the blocks are crushed and a milled to a desired particle size.

The desired particle size will depend on the thickness of the piezoelectric film or component which is to be produced from the paste.

**Piezoelectric composite material**

The piezoelectric composite material which in its green i.e. not cured form is a paste, contains a polymer matrix mixed with a powder of sintered piezoelectric particles in an amount of 15-75 vol% relative to the matrix, normally between 40-60 vol% relative to the matrix and e.g. additives in a minor amount i.e. less than 10 vol%, normally less than 3 vol% of the total mixture. There is a link between the amount of powder and the final thickness of the layer, but the optimal amount of contained powder also depends on the used polymer.

The additives can e.g. be used to improve the viscosity or the wetting ability of the paste. After having prepared the paste, the paste is either deposited directly on a substrate or on a previously deposited layer of paste in order to increase the thickness of the component.

The composite material has a 0-3 connectivity pattern, which means that the ceramic particles are randomly dispersed in the polymer matrix.

Between the depositing of each layer of the paste and/or after all layers of paste has been deposited on the substrate is finished, the deposited layer(s) is cured and the curing process normally takes place at an increased temperature below 300°C or between 50-150°C or alternatively at a temperature between 70-130°C for a time period of between 5-30 minutes. The curing can also take place at room temperature but then the curing time will be longer. The curing process can also comprise or consist of a treatment of UV-light.

The final thickness of the layered structure i.e. the piezoelectric film is normally between 10-300 $\mu$m, or at least above 50 $\mu$m, normally between 80 um to 300 $\mu$m. Generally, a thick film is defined as a layer of material on a substrate having a final thickness above1 um, whereas thin films have a final thickness of less than 1 um. After curing a poling process is carried out at elevated temperature polarising the deposited and cured piezoelectric composite material. For example, the polarisation may be performed by applying a suitable polarisation electrical field to the electrodes, e.g. an electrical field of between 2-10 kV/mm, e.g. between 5-10 kV/mm. The polarisation step may be performed at elevated temperatures, e.g. at temperatures between 80-160°C. In some embodiments the polarisation may be performed by corona poling and standard polarisation by applying an electric field between the electrodes. It has been found that the poling time may be kept below 30 min, e.g. between 10-20 min, when using corona poling, thus allowing for a short manufacturing time and reducing production costs. It might though be difficult to perform corona poling over large areas maintaining the same field distribution, in such a case the standard method would be preferred.

## Depositing method

The piezoelectric material according to the application allows for use of a deposition method such as screen-printing, pad-printing, spraying or other methods where the piezoelectric material due to its flowing properties is transferred to a desired substrate surface. The deposition and curing steps may be repeated so as to build up a layer of increased thickness from individual thinner layers, and/or so as to build up complicated patterns of piezoelectric material. Screen printing is a through transfer process utilizing a screen as the medium for depositing a film on a substrate. With the aid of a squeegee, the film is transferred through the prepared screen to the substrate using consistent pressures and print speeds, either automatically or manually. When using this method for depositing the paste need not be liquid but need just be plastic and formable.

Pad printing is a printing process that can transfer a 2-D image onto a 3-D object using an indirect offset printing process that involves an image being transferred from a printing plate (cliché) via a silicone pad onto a substrate (surface to be printed). Pad printing has until today been used for printing on otherwise impossible products in many industries including medical, automotive, promotional, apparel, electronics, appliances, sports equipment and toys. It can also be used to deposit functional materials such as conductive inks, adhesives, dyes and lubricants. Physical changes within the transferred film both on the cliché and on the pad allow it to leave the etched image area in favour of adhering to the pad, and to subsequently release from the pad in favour of adhering to the substrate i.e. the material being printed. The properties of the silicone pad enable it to pick the image up from a flat plane and transfer it to a variety of surface i.e. flat, cylindrical, spherical, compound angles, textures, concave surfaces, convex surfaces.

The piezoelectric film might also be deposited by spraying, if this method is used the paste needs to have a relatively low viscosity.

Generally, the film according to the present invention is not produced in bulk form i.e. as sheets or cables which after production is adapted in shape and attached to a surface of the substrate. The thick film is instead created by applying the paste directly to the substrate, it is not necessary to regulate to thickness of the film e.g. by grinding after the film has been made and it is not necessary to fasten the thick film to the substrate surface e.g. by gluing but it might be necessary to pre-treat the surface of the substrate in order to get an acceptable attachment between the added piezoelectric material and the substrate surface. Bonding between the piezoelectric material and the e.g. pre-treated surface normally happens during deposition.

When applying the layer by screen or pad printing it is possible to build up a layer of the material having desired dimensions and pattern. Using other techniques for providing a layer such as e.g. spraying provides less control of creating a layer having a specific thickness and patterning. By screen printing one deposits the material directly on the final substrate/structure therefore the whole processing is simpler and more robust e.g. no need for intermediate bonding is needed.

It is an advantage of embodiments of the process described herein that it does not require any subsequent processing of the deposited layer, such as bonding/gluing lapping or sanding to obtain the desired thickness of the layer.

## Substrate

The piezoelectric material according to the application can be used on substrates comprising temperature sensitive materials such as paper, fabrics/textiles or plastics which do not allow use of high temperatures, and/or the piezoelectric material can be used on hard rigid substrates having large or curved surfaces made of e.g. polymers, glass, metal plastics, ceramics, etc. or a combination thereof where it is possible to create a film of the piezoelectric material directly on a surface. In order to optimize the resulting film, it is just necessary to choose an appropriate depositing method.

**Piezoelectric component**

A piezoelectric component according to the present application may comprise one or more electrodes, e.g. one or more electrode layers. For example the layer of piezoelectric composite material may be sandwiched between respective electrode layers. Alternatively or additionally, the piezoelectric component may comprise a substrate, an electrode layer disposed on the substrate, and a layer of cured piezoelectric composite material deposited on top of the electrode layer. The electrode layer may be embodied as a patterned structure covering a part of the substrate surface while leaving another part of the substrate surface exposed, and the layer of cured piezoelectric composite material may thus cover the electrode and the exposed part of the substrate surface. For example, the electrode may have the form of a set of interdigitated electrodes.

The piezoelectric component may be used as a piezoelectric sensor, actuator and/or transducer, e.g. as a sensor for detecting stress and/or strains in a material. By the process according to the application it is possible to provide a low profile integrated sensor which is directly deposited on a base structure. Also, the relatively low temperature (<200°C) applied during curing and poling makes it possible to apply the piezoelectric components to a number of substrates which cannot tolerate higher temperatures.

**Examples**

In the following description, reference is made to the accompanying figures, which show by way of illustration how the invention may be practiced.

Preparation of the powder

In order to illustrate the invention, a number of powders which can be used with the claimed invention have been prepared. The ceramic powders Pz24, Pz26 and Pz59 are commercially available through MEGGITT A/S. The lead free powder is of the KNN (potassium sodium niobate) family piezoceramic material, which has been developed at MEGGITT A/S and is not commercially available yet.

An amount of approximately 10g of each powder is subjected to a pressure of above 500 bars for at least one minute, thereby obtaining a pressed part. The pressed parts are then sintered in a furnace at 1100-1300 °C for 1 - 2 hours. The sintering conditions depend on the powder composition and type of the material.

After sintering the pressed parts are crushed and then ball-milled to a desired particle size of $d_{0.5}= 10\text{-}30\ \mu m$. Generally, the desired particle size distribution will depend on the deposition technique used for applying the paste, which is prepared on the basis of this powder and of the desired thickness of the prepared films.

Paste formulation

The concentration of the piezoelectric particles in the mixture depends on the density ratio between the sintered piezoelectric particles and the polymer matrix used, and on a desired composition (vol. % of the powder in the mixture). Therefore, to calculate an amount of polymer matrix in the mixture, the following simple equation can be used:

$$m_{polymer} = m_{powder}\ \frac{\rho_{polymer}}{\rho_{powder}}\left(\frac{100}{Vol.\%} - 1\right) \qquad\qquad (1)$$

where $m_{polymer}$, $\rho_{polymer}$ and $m_{powder}$, $\rho_{powder}$ are the weights and densities of the polymer and piezoelectric powder, respectively, and $Vol.\%$ is the desired volume percentage of the powder in the mixture.

For all types of the pastes prepared on the basis of Pz24, Pz26, Pz59, and KNN-based powders, a commercially available polymer matrix from DuPont (DP8155) has been used. To improve the fluidity of the paste, a commercially available thinner from DuPont (DP8210) has been added. An alternative polymer material from DuPont (DP3571) has also been tried for use as polymer matrix; however, the results obtained were not as good as those in the case of DP8155 polymer in terms of the piezoelectric performance of the obtained composite material. This was due to the relatively high conductivity of the composite material based on this polymer which made it difficult to pole the composite material and obtain satisfying piezoelectric performance.

The properties of the piezoelectric powders, polymer matrix, and thinner that have been used for preparation are summarized in table 1.

Table 1: Properties of piezoelectric particles and polymer matrix used in examples

| Material: | Relative permittivity (at 25 °C, 1 kHz) | Density (g/cm$^3$) |
|---|---|---|
| Pz24 | 400 | 7.70 |
| Pz26 | 1300 | 7.70 |
| Pz59 | 5100 | 7.90 |
| KNN-based | 920 | 4.80 |
| DuPont DP8155 | 8 | 1.13 |

All components (piezoelectric particles/powder, polymer matrix and thinner) are mixed together, and after mixing the ingredients, the mixture was run through a triple-roller mill to ensure a homogenous paste. First, the piezoelectric powder is mixed with the polymer matrix, and then, from 5 to 15 drops of the thinner is added to the mixture, to ensure a good fluidity of the paste. Example of the amounts of the ingredients that have been used for the paste preparation is presented in Table 2.

Table 2: Amounts of ingredients used to prepare the paste of composite piezoelectric material

| Vol.% of piezoelectric particles | Type of piezoelectric particles | Weights of the ingredients in the mixture, g | | |
|---|---|---|---|---|
| | | Piezoelectric particles | Polymer (DuPont DP8155) | Thinner (DuPont DP8120) |
| 40 | Pz24 | 25.0 | 5.5 | 5 drops |
| | Pz26 | 25.0 | 5.6 | 5 drops |
| | Pz59 | 25.0 | 5.4 | 5 drops |
| 50 | Pz24 | 25.0 | 3.7 | 8 drops |
| | Pz26 | 25.0 | 3.8 | 8 drops |
| | Pz59 | 25.0 | 3.6 | 8 drops |
| 60 | Pz24 | 25.0 | 2.5 | 10 drops |
| | Pz26 | 25.0 | 2.6 | 10 drops |
| | Pz59 | 25.0 | 2.4 | 10 drops |
| 38 | KNN-based | 19.5 | 7.5 | 15 drops |

It has been attempted to increase the volume % of PZT power to 70% for the case of Pz24 powder but without any success, due to very low viscosity of the paste making the paste incompatible with the screen- and pad- printing technology.

The polarisation parameters, including the polarisation time, voltage, and temperature have been investigated and optimized for all pastes prepared. A summary of optimal poling conditions and obtained piezoelectric coefficients $d_{33}$ are summarized in table 3.

Table 3: Optimized poling parameters for the different composite piezoelectric materials and obtained piezoelectric coefficients $d_{33}$

| Material | Vol.% of piezoelectric particles | Poling conditions | | | $d_{33}$, pC/N |
|---|---|---|---|---|---|
| | | Temperature, °C | Field, kV/mm | Time, min | |
| Pz24 | 40 | 90 | 4.0 | 10 | 29-30 |
| Pz24 | 50 | 90 | 4.0 | 10 | 34-36 |

(continued)

| Material | Vol.% of piezoelectric particles | Poling conditions | | | $d_{33}$, pC/N |
| | | Temperature, °C | Field, kV/mm | Time, min | |
|---|---|---|---|---|---|
| Pz24 | 60 | 90 | 3.0 | 10 | 28-29 |
| Pz26 | 40 | 90 | 5.0 | 10 | 26-27 |
| Pz26 | 50 | 90 | 4.0 | 10 | 28-30 |
| Pz26 | 60 | 90 | 3.0 | 10 | 26 |
| Pz59 | 40 | 90 | 4.0 | 10 | 16 |
| Pz59 | 50 | 90 | n/a | n/a | n/a |
| pz59 | 60 | 90 | n/a | n/a | n/a |
| KNN-based | 38 | 90 | 4.0 | 10 | 20-25 |

For the pastes based on Pz24 and Pz26 materials, both an increasing poling field and an increasing temperature contribute to increase the piezoelectric coefficient of the material up to 30-35 pC/N saturating after about 10 minutes of poling. The poling field has been found to be a parameter which influences the possibility of obtaining a high piezoelectric coefficient, however, it has been difficult to apply higher poling fields in the case of composite piezoelectric materials with higher concentration of piezoelectric particles in the mixture (more than 50 Vol.%). Pastes based on Pz59 material have been found to be difficult to pole, showing relatively low piezoelectric coefficients $d_{33}$.

The poling temperature plays also a role for the successful poling of composite piezoelectric materials, however, it was difficult to increase the poling temperature more than 90 - 100°C, since the polymer matrix starts to soften at these temperature, complicating the poling procedure and leading to significant increase of the current and consequently to the electrical breakdown.

It has been also observed, that the relative permittivity ($\varepsilon$) of the materials increases after the poling of the material and the dielectric loss tangent drops significantly for the most of the samples (see Table 4).

**Table 4:** Characterization results for Pz24 based paste, printed on Al substrates (measured at 1 kHz)

| Sample: | Before poling | | After poling | | $d_{33}$, pC/N |
| | $\varepsilon$ | tan $\delta$, % | $\varepsilon$ | tan $\delta$, % | |
|---|---|---|---|---|---|
| 1 | 88,5 | 5,3 | 93,6 | 5,8 | 33,5 |
| 2 | 88,5 | 18,0 | 97,5 | 5,3 | 34,3 |
| 3 | 89, 7 | 5,4 | 93,4 | 5,7 | 33,1 |
| 4 | 89, 4 | 8,1 | 96,5 | 5,6 | 32,8 |
| 5 | 86,5 | 31,0 | 94,0 | 5,8 | 32,0 |

The dielectric and piezoelectric properties of the pastes also depend on the substrate on which the paste is applied.

The paste on the basis of Pz24 piezoelectric material with 50 Vol.% of the powder in the mixture has been found as an optimal solution in relation to piezoelectric performance of a composite piezoelectric materials on the basis of this paste. The paste on the basis of KNN-based material shows in general lower piezoelectric performance than that for the PZT-based materials, giving however another advantages such as biocompatibility and more simple recycling of the components on the basis of this paste.

Paste deposition and post processing

The piezoelectric paste based on the piezoelectric paste containing 50 vol% Pz24 was deposited on a substrate using a screen-printing technique, where the paste was deposited in 3 layers through a mesh with a desired pattern onto a ceramic or fabric substrate. The printed thick films were heat treated for 10 minutes in an oven at 100°C between each layer deposition, and after all 3 layers was deposited, the structure was cured at 100°C for 15 minutes. The final thickness of the deposited layers was in the range of 100 - 120 $\mu$m. After curing and screen printing of electrodes, polarisation of the piezoelectric film was carried out at an elevated temperature of 90°C in an oven with and applied an external field of 3 - 5 kV/mm (depending on the type of the paste used).

**List of figures:**

Figure 1 shows an example of fabricated piezoelectric structure on textile (a) - top view, b) - cross section view.
Figure 2 shows a cross-section of piezoelectric sensor / actuator. B and T correspond to bottom, and top silver screen-printed electrodes, respectively.
Figure 3 shows an interdigitated electrodes structure (a) and top view of motion sensor on the basis of composite piezoelectric material printed on textile (b).
Figure 4 shows an example of Structural Health Monitoring System (SHM) on aircraft

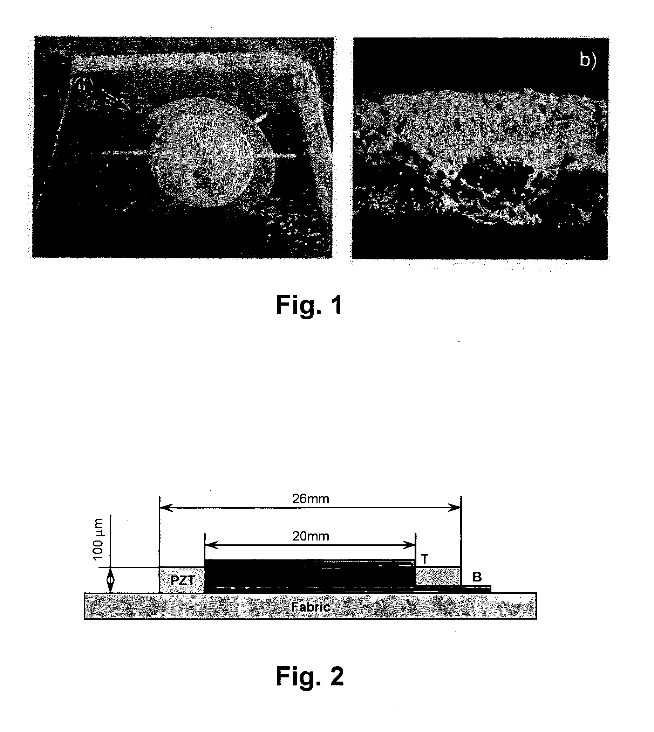

Figure 1 illustrates an example of a piezoelectric sensor component. Figure 1 a shows a top view of the component, while Figure 1b shows a cross sectional view of the component. The component comprises a substrate 1, top and bottom electrodes 2, and a thick film layer of a composite piezoelectric material 3 as described herein. The structure consists of a bottom electrode, composite piezoelectric materials based on the piezoelectric paste containing 50 vol% Pz24, and a top electrode.

Diameter of the bottom and top electrodes are 20 mm, the diameter of piezoelectric structure is 26 mm. A schematic cross sectional view of such sensor / actuator (e.g. buzzer) is shown in Figure 2. The structure represents a planar sandwich structure having an active piezoelectric layer in between of bottom and top screen-printed electrodes.

The electrodes are made of a suitable conductive material, such as a metal, e.g. copper, gold, platinum, etc. or alloys thereof. In this particular case (piezoelectric sensor (buzzer)), the electrodes represent silver based electrodes (commercially available silver paste electrodes e.g. DuPont 5000 or DuPont 5028), suitable for screen- or pad- printing technology. The electrode structure is cured at the same conditions as in the case of curing of the paste of composite piezoelectric material -100 °C for 10 - 15 min.

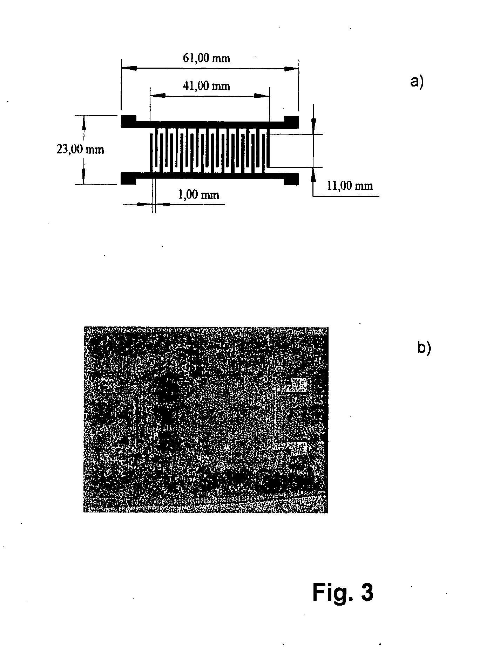

Figure 3 illustrates an example of a piezoelectric sensor component with interdigitated electrodes structure. The electrodes of the sensor in Figure 3 are in the form of a pair of interdigitated electrodes, each having a comb-like shape. The electrodes are made of the same conductive material suitable for screen- and pad- printing technology as in the case described above (see Figure 1 and Figure 2). The electrodes may be deposited by screen printing on the substrate. In some embodiments, the spacing between the interdigitated electrodes may be 100 $\mu$m or larger. The piezoelectric composite material may be manufactured and deposited on top of the electrodes as described herein. As can be most clearly seen from Figure 1 and Figure 2, the layer of piezoelectric composite material may have a layer thickness larger than the thickness of the electrodes, and in this case. The piezoelectric composite material fills the gaps between the interdigitated electrodes and covers the electrodes, only leaving electrode terminals unexposed.

The components illustrated in fig. 2 and 3 can also be used to generate electrical energy from vibrations i.e. for energy harvesting applications.

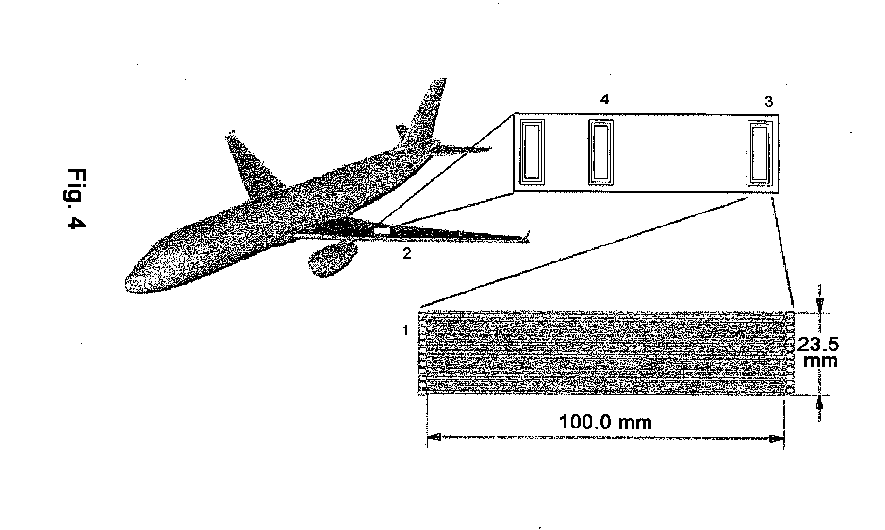

Fig. 4 illustrates an example of a transducer, made from the claimed piezoelectric composite material using an interdigitated electrode structure (1) for Structural Health Monitoring (SHM) of an aircraft. SHM is a collective term for advanced technologies using sensor networks for monitoring the structural integrity of structures of high importance. In this case, each transducer is a linear array, i.e. consisting of a row of elements. Acoustic waves such as Lamb waves can be generated in the structure of interest, e.g. the fuselage of an aircraft wing (2), by sending electrical signals to one of the transducer arrays (3). By analysing the acoustic waves received by another transducer array (4), it is possible to detect structural defects such as cracks.

**Claims**

**1.** A paste of composite piezoelectric material to be deposited on a substrate by a deposition method comprising:

- a matrix of polymer having a relative permittivity $\geq 3$, normally $\geq 6$,
- sintered piezoelectric particles having a relative permittivity in the range of 100-5000, normally in the range of 400-1000, and an average particle size between 1 and 50 $\mu$m, although the particles should be smaller than 1/10 of the final thickness of the final layer of piezoelectric material, and
- additives improving viscosity and/or wetting ability of the paste in order to adapt the viscosity to the deposition method
further the final paste has

--a 0-3 connectivity pattern,
-- a content of sintered piezoelectric particles between 15 and 75 vol%, normally between 40 and 60 vol%.

2. A paste according to claim 1, wherein the sintered piezoelectric particles are manufactured from a ceramic piezoelectric active powder which is first pressed and then sintered at a temperature above 1100°C for a period of at least 0.5 hours, normally at a temperature between 1100-1300° for 1-2 hours.

3. A paste according to claim 2, wherein the sintered piezoelectric material has been subjected to crushing and milling to obtain a desired particle size of $d_{0.5}$ = 1-50 $\mu$m, normally 7-15 $\mu$m.

4. A paste according to any preceding claim, wherein the cured polymer matrix is flexible having a Young's Modulus $E \leq 10$ GPa, normally $E \leq 4$ GPa.

5. A paste according to any preceding claim, wherein the viscosity of the paste is $\leq 15$ Pa·s at a shear rate equal to 33.3 (1/sec) and satisfying wetting properties between the paste and substrate are obtained.

6. A paste according to any preceding claim, wherein the binding matrix comprises or consists of a fluoride based polymer e.g. Polyvinylidene fluoride (PVDF).

7. A paste according to any preceding claim, wherein the sintered piezoelectric particles are made of a PZT material.

8. A paste according to any preceding claim, wherein the thickness of the final layer of piezoelectric material is >10 $\mu$m.

9. A method of preparing and depositing a composite piezoelectric material comprising the steps

1) preparing sintered piezoelectric particles having a relative permittivity in the range of 100-5000, normally in the range of 400-1000, and an average particle size between 1 and 50 $\mu$m, although the particles should be smaller than 1/10 of the final thickness of the final layer of piezoelectric material,
2) mixing between 15 and 75 vol%, normally between 40 and 60 vol%, normally between 40 and 50 vol% of sintered piezoelectric particles with 60-40 wt% of a polymer matrix having a relative permittivity $\geq 3$, normally $\geq$ 6,and suitable additives improving viscosity and/or wetting ability of the final paste,
3) agitating the mixture until a homogenous paste having a desired viscosity and satisfying wetting properties between paste and a substrate is obtained,
4) depositing the paste directly on the substrate by e.g. screen-printing, pad-printing, spraying or other methods where the piezoelectric material due to its flowing properties can be transferred to a desired substrate surface.

10. A method of preparing a composite piezoelectric material according to claim 9, wherein the agitation is performed in a roller mill e.g. a triple roller mill.

11. A method of manufacturing a piezoelectric component, the method comprising:

- depositing a layer of a paste of piezoelectric material according to one of claims 1-8 on a substrate, the layer being thicker than 10 $\mu$m, normally between 10 - 30 $\mu$m, the final layer on the substrate might be formed by depositing more than one layer of paste and each layer or combination of layers are created in the final functional thickness and shape by deposition,
- curing the deposited layer of composite piezoelectric material.

12. A method of manufacturing a piezoelectric component according to claim 11, wherein the curing comprises heating the deposited layer on the substrate at a temperature below 300 °C, typically in the range of 90-150°C.

13. A method of manufacturing a piezoelectric component according to claims 11 or 12, wherein the layer(s) of composite piezoelectric material are deposited by screen-printing or pad-printing.

14. A method of manufacturing a piezoelectric component according to claims 11, 12 or 13, wherein the substrate is a woven or non-woven textile, paper, polymer or composite material or a curved or non-curved surface e.g. made of metal, ceramic or plastic.

15. A method of manufacturing a piezoelectric component according to any of claims 11-14, wherein the component is used for a Structural Health Monitoring (SHM) system, e.g. detecting physical changes in the substrate, or the component is used for energy harvesting.

**Patentansprüche**

1. Paste aus piezoelektrischem Verbundmaterial, welches durch ein Abscheidungsverfahren auf ein Substrat abzuscheiden ist, umfassend:

   - eine Polymermatrix mit einer relativen Dielektrizitätskonstante von $\geq 3$, normalerweise $\geq 6$,
   - gesinterte piezoelektrische Partikel mit einer relativen Dielektrizitätskonstante im Bereich von 100-5000, normalerweise im Bereich von 400-1000, und einer durchschnittlichen Partikelgröße zwischen 1 und 50 $\mu$m, obwohl die Partikel kleiner als 1/10 der Endstärke der letzten Schicht von piezoelektrischem Material sein sollten, und
   - Additive, welche die Viskosität und/oder die Benetzungsfähigkeit der Paste verbessern, um die Viskosität an das Abscheidungsverfahren anzupassen, ferner besitzt die Endpaste

   -- ein Verbindungsmuster von 0-3,
   -- einen Gehalt an gesinterten piezoelektrischen Partikeln von zwischen 15 und 75 Vol-%, normalerweise zwischen 40 und 60 Vol-%.

2. Paste nach Anspruch 1, wobei die gesinterten piezoelektrischen Partikel aus einem keramischen piezoelektrisch aktiven Pulver hergestellt sind, welches zunächst gepresst und dann bei einer Temperatur über 1100 °C für einen Zeitraum von zumindest 0,5 Stunden, normalerweise bei einer Temperatur zwischen 1100-1300 °C für 1-2 Stunden, gesintert wird.

3. Paste nach Anspruch 2, wobei das gesinterte piezoelektrische Material einer Zerkleinerung und einer Mahlung unterworfen worden ist, um eine erwünschte Partikelgröße von $d_{0,5} = 1$-$50$ $\mu$m, normalerweise 7-15 $\mu$m, zu erhalten.

4. Paste nach einem der vorgehenden Ansprüche, wobei die gehärtete Polymermatrix flexibel ist und einen Elastizitätsmodul von $E \leq 10$ GPa, normalerweise $E \leq 4$ GPa, aufweist.

5. Paste nach einem der vorgehenden Ansprüche, wobei die Viskosität der Paste $\leq 15$ Pa.s bei einer Schergeschwindigkeit gleich 33,3 (1/Sek) beträgt, und zufriedenstellende Benetzungseigenschaften zwischen der Paste und dem Substrat erhalten sind.

6. Paste nach einem der vorgehenden Ansprüche, wobei die Bindematrix ein auf Fluorid basierendes Polymer umfasst oder aus einem solchen Polymer, z.B. Polyvinylidenfluorid (PVDF), besteht.

7. Paste nach einem der vorgehenden Ansprüche, wobei die gesinterten piezoelektrischen Partikel aus einem PZT-Material hergestellt sind.

8. Paste nach einem der vorgehenden Ansprüche, wobei die Stärke der letzten Schicht von piezoelektrischem Material >10 $\mu$m beträgt.

9. Verfahren zur Herstellung und Abscheidung eines piezoelektrischen Verbundmaterials umfassend folgende Schritte

   - Herstellung von gesinterten piezoelektrischen Partikeln mit einer relativen Dielektrizitätskonstante im Bereich von 100-5000, normalerweise im Bereich von 400-1000, und einer durchschnittlichen Partikelgröße zwischen 1 und 50 $\mu$m, obwohl die Partikel kleiner als 1/10 der Endstärke der letzten Schicht von piezoelektrischem Material sein sollten,
   2) Mischen von zwischen 15 und 75 Vol-%, normalerweise zwischen 40 und 60 Vol-%, normalerweise zwischen 40 und 50 Vol-% von gesinterten piezoelektrischen Partikeln mit 60-40 Gew.-% einer Polymermatrix mit einer relativen Dielektrizitätskonstante von $\geq 3$, normalerweise $\geq 6$, und geeigneten Additiven, die die Viskosität und/oder die Benetzungsfähigkeit der Endpaste verbessern,
   3) Rühren der Mischung, bis eine homogene Paste mit einer erwünschten Viskosität und zufriedenstellenden Benetzungseigenschaften zwischen Paste und einem Substrat erhalten ist,
   4) Abscheiden der Paste direkt auf das Substrat z.B. durch Siebdruck, Tampondruck, Sprühen oder andere Verfahren, bei denen sich das piezoelektrische Material durch seine Fließeigenschaften auf eine erwünschte Substratoberfläche übertragen lässt.

**10.** Verfahren zur Herstellung eines piezoelektrischen Materials nach Anspruch 9, wobei das Rühren in einer Walzenmühle, z.B. einer Dreiwalzenmühle, durchgeführt wird.

**11.** Verfahren zur Herstellung eines piezoelektrischen Bestandteils, welches Verfahren umfasst:

- Abscheiden einer Schicht einer Paste aus piezoelektrischem Material nach einem der Ansprüche 1 bis 8 auf ein Substrat, wobei die Schicht dicker als 10 $\mu$m, normalerweise zwischen 10-30 $\mu$m ist, die letzte Schicht auf dem Substrat durch Abscheiden von mehr als einer Schicht von Paste gebildet werden könnte, und jede Schicht oder Kombination von Schichten in der endgültigen funktionellen Dicke und Form durch Abscheiden gebildet wird,
- Aushärten der abgeschiedenen Schicht von piezoelektrischem Verbundmaterial.

**12.** Verfahren zur Herstellung eines piezoelektrischen Bestandteils nach Anspruch 11, wobei das Aushärten ein Erhitzen der auf das Substrat abgeschiedenen Schicht auf eine Temperatur unter 300 °C, typischerweise im Bereich von 90-150 °C, umfasst.

**13.** Verfahren zur Herstellung eines piezoelektrischen Bestandteils nach den Ansprüchen 11 oder 12, wobei die Schicht(en) von piezoelektrischem Verbundmaterial durch Siebdruck oder Tampondruck abgeschieden wird/werden.

**14.** Verfahren zur Herstellung eines piezoelektrischen Bestandteils nach den Ansprüchen 11, 12 oder 13, wobei das Substrat ein gewebtes Textil oder ein Vliesstoffgewebe, Papier, Polymer oder Verbundmaterial oder eine gekrümmte oder nicht gekrümmte Oberfläche, z.B. aus Metall, Keramik oder Kunststoff, ist.

**15.** Verfahren zur Herstellung eines piezoelektrischen Bestandteils nach einem der Ansprüche 11 bis 14, wobei der Bestandteil für ein Structural Health Monitoring (SHM) System, z.B. für die Ermittlung physischer Änderungen im Substrat, oder der Bestandteil zur Energiegewinnung verwendet wird.

**Revendications**

**1.** Pâte de matériau piézo-électrique composite à déposer sur un substrat par un procédé de dépôt comprenant:

- une matrice de polymère ayant une permittivité relative $\geq 3$, normalement $\geq 6$,
- des particules piézoélectriques frittées ayant une permittivité relative comprise entre 100 et 5000, normalement comprise entre 400 et 1000, et une taille moyenne de particules comprise entre 1 et 50 $\mu$m, alors que les particules doivent être inférieures à 1/10 de l'épaisseur finale de la couche finale de matériau piézo-électrique, et
- des additifs améliorant la viscosité et/ou la capacité de mouillage de la pâte afin d'adapter la viscosité au procédé de dépôt,
en outre la pâte finale présente

-- un modèle de connectivité de 0-3,
-- une teneur en particules piézoélectriques frittées comprise entre 15 et 75% en volume, normalement comprise entre 40 et 60% en volume.

**2.** Pâte selon la revendication 1, dans laquelle les particules piézoélectriques frittées sont fabriquées à partir d'une poudre de céramique piézoélectrique active qui est d'abord pressée, puis frittée à une température supérieure à 1100 °C pour une période d'au moins 0,5 heures, normalement à une température comprise entre 1100-1300 °C pour 1 à 2 heures.

**3.** Pâte selon la revendication 2, dans laquelle le matériau piézo-électrique fritté a été soumis à l'écrasement et au broyage pour obtenir une taille de particule souhaitée de $d_{0,5}$ = 1-50 $\mu$m, normalement 7 à 15 $\mu$m.

**4.** Pâte selon l'une quelconque des revendications précédentes, dans laquelle la matrice de polymère durcie est flexible ayant un module d'Young E $\leq$ 10 GPa, normalement E $\leq$ 4 GPa.

**5.** Pâte selon l'une quelconque des revendications précédentes, dans laquelle la viscosité de la pâte est ≤ 15 Pa·s à un taux de cisaillement égal à 33,3 (1/sec), et des propriétés de mouillage satisfaisantes entre la pâte et le substrat sont obtenues.

**6.** Pâte selon l'une quelconque des revendications précédentes, dans laquelle la matrice de liaison comprend ou est constituée d'un fluorure à base de polymère, par exemple le polyfluorure de vinylidène (PVDF).

**7.** Pâte selon l'une quelconque des revendications précédentes, dans laquelle les particules piézoélectriques frittées sont faites d'un matériau de PZT.

**8.** Pâte selon l'une quelconque des revendications précédentes, dans laquelle l'épaisseur de la couche finale de matériau piézo-électrique est >10 $\mu$m.

**9.** Procédé de préparation et de dépôt d'un matériau piézo-électrique composite comprenant les étapes consistant à

- préparer des particules piézoélectriques frittées ayant une permittivité relative comprise entre 100 et 5000, normalement comprise entre 400 et 1000, et une taille moyenne de particules comprise entre 1 et 50 $\mu$m, alors que les particules doivent être inférieures à 1/10 de l'épaisseur finale de la couche finale de matériau piézo-électrique, et

2) mélanger entre 15 et 75% en volume, normalement entre 40 et 60% en volume, normalement entre 40 et 50% en volume de particules piézoélectriques frittées avec 60 à 40% en poids d'une matrice polymère ayant une permittivité relative ≥ 3, normalement ≥ 6, et des additifs appropriés améliorant la viscosité et/ou la capacité de mouillage de la pâte finale,
3) agiter le mélange jusqu'à obtenir une pâte homogène ayant une viscosité souhaitée et des propriétés satisfaisantes de mouillage entre la pâte et le substrat,
4) déposer la pâte directement sur le substrat par exemple au moyen de la sérigraphie, la tampographie, la pulvérisation ou d'autres procédés où le matériau piézoélectrique en raison de ses propriétés d'écoulement peut être transféré à une surface de substrat souhaitée.

**10.** Procédé de préparation d'un matériau piézo-électrique composite selon la revendication 9, dans lequel l'agitation est effectuée dans un broyeur à rouleaux, par exemple un broyeur à rouleaux triple.

**11.** Procédé de fabrication d'un composant piézo-électrique, le procédé comprenant:

- le dépôt d'une couche d'une pâte de matériau piézo-électrique selon l'une des revendications 1 à 8 sur un substrat, la couche étant plus épaisse que 10 $\mu$m, normalement comprise entre 10 et 30 $\mu$m, la couche finale sur le substrat pourrait être formée en déposant plus d'une couche de pâte et chaque couche ou combinaison de couches est créé dans l'épaisseur et la forme finales fonctionnelles par le dépôt,
- le durcissement de la couche déposée de matériau piézo-électrique composite.

**12.** Procédé de fabrication d'un composant piézo-électrique selon la revendication 11, dans lequel le durcissement comprend le chauffage de la couche déposée sur le substrat à une température inférieure à 300 °C, typiquement comprise entre 90 et 150 °C.

**13.** Procédé de fabrication d'un composant piézo-électrique selon les revendications 11 ou 12, dans lequel la couche ou les couches de matériau piézoélectrique composite est/sont déposée(s) par la sérigraphie ou la tampographie.

**14.** Procédé de fabrication d'un composant piézo-électrique selon les revendications 11, 12 ou 13, dans lequel le substrat est un tissu tissé ou non tissé, du papier, un matériau polymère ou composite ou une surface, incurvée ou non incurvée par exemple réalisée en métal, en céramique ou en matière plastique.

**15.** Procédé de fabrication d'un élément piézo-électrique selon l'une quelconque des revendications 11 à 14, dans lequel le composant est utilisé pour les systèmes dits SHM (Structural Health Monitoring), par exemple la détection des changements physiques dans le substrat, ou le composant est utilisé pour la récupération d'énergie.

**Fig. 1**

**Fig. 2**

a)

b)

**Fig. 3**

Fig. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5702629 A
- US 5951908 A
- US 4917810 A

### Non-patent literature cited in the description

- **X. LI ; Y.ZHANG.** Analytical study of piezoelectric paint sensor for acoustic emission-based fracture monitoring. *Fatigue & Fracture of Engineering Materials & Structures,* August 2008, vol. 31 (8), 684-694
- In-situ Fabricated Smart Material Active sensors for structural Health Monitoring. **V. GIURGIUTIU ; BIN LIN.** Smart Materials III. Proceedings of SPIE, vol. 5648
- **I. PAYO ; J.M. HALE.** Dynamic characterization of piezoelectric paint sensors under biaxial strain. *Sensors and Actuators,* 2010, vol. A 163, 150-158
- **R. LAHTINEN et al.** A piezopaint-based sensor for monitoring structure dynamics. *Smart Materials and Structures,* 2007, vol. 16, 2571-2576
- **K. ARLT ; M. WEGENER.** Piezoelectric PZT/PVDF - copolymer 0-3 Composites: Aspects on Film Preparation and Electrical Poling. *Fraunhofer Institute for Applied Polymer Research (IAP), IEEE Transactions on Dielectrics and Electrical Insulation,* August 2010, vol. 17 (4